# EUROPEAN PATENT SPECIFICATION

(11) **EP 4 507 194 B1**
(45) Date of publication and mention of the grant of the patent: **17.09.2025**
(21) Application number: 24193511.3
(22) Date of filing: 08.08.2024
(51) Int. Cl.: H02S 40/44, F24S 10/50, F24S 80/30

(54) **A COLUMN OF HYBRID PHOTOVOLTAIC AND THERMAL SOLAR MODULES**
EINE KOLONNE AUS HYBRIDEN PHOTOVOLTAISCHEN UND THERMISCHEN SOLARMODULEN
UNE COLONNE DE MODULES SOLAIRES HYBRIDES PHOTOVOLTAÏQUES ET THERMIQUES

(30) Priority: 10.08.2023 IT 202300017145
(43) Date of publication of application: 12.02.2025
(73) Proprietor: Eff&Giemme S.a.s. di Michele Angelo Manassero, 12100 Cuneo (IT)
(72) Inventor: CALLEGARI, Guido, I-10125 TORINO (IT); MANASSERO, Michele Angelo, I-12100 CUNEO (IT); MEROLLA, Eleonora, I-80069 VICO EQUENSE (NA) (IT); SIMEONE, Paolo, I-20154 MILANO (IT)
(74) Representative: Fioravanti, Corrado

(56) References cited:
- EP-A1- 3 316 478
- WO-A1-2021/006726
- WO-A1-2022/179778
- WO-A2-2020/161548
- DE-U1- 202019 104 195
- IT-A1- FO20 090 004
- US-A1- 2010 154 864
- US-B2- 9 263 986
- HEGAZY A A ED - KRAJACIC GORAN ET AL: "Comparative study of the performances of four photovoltaic/thermal solar air collectors", ENERGY CONVERSION AND MANAGEMENT, ELSEVIER SCIENCE PUBLISHERS, OXFORD, GB, vol. 41, no. 8, 1 May 2000 (2000-05-01), pages 861 - 881, XP004321191, ISSN: 0196-8904, DOI: 10.1016/S0196-8904(99)00136-3
- SOPIAN K ET AL: "Performance of a double pass photovoltaic thermal solar collector suitable for solar drying systems", ENERGY CONVERSION AND MANAGEMENT, ELSEVIER SCIENCE PUBLISHERS, OXFORD, GB, vol. 41, no. 4, 1 March 2000 (2000-03-01), pages 353 - 365, XP004243587, ISSN: 0196-8904, DOI: 10.1016/S0196-8904(99)00115-6

## Description

### Technical field

The present invention pertains to the field of photovoltaic systems integrated on building facades and relates, in particular, to hybrid photovoltaic and thermal solar modules (henceforth referred to as "hybrid PVT solar modules"), aggregated in different possible configurations and arranged to be assembled in vertical columns, each including a photovoltaic generator (or "PV generator") intended for the production of electrical energy and thermal solar components for the production of thermal energy, in the form of a heated fluid, to be used for thermal and/or sanitary uses in buildings.

### Prior art

US 9263986 B2 discloses a hybrid solar manifold assembly lying on the slope of a roof. The manifold assembly consists of the union of two frames that perimetrically close two opposing sides of a photovoltaic panel. On a first side of the photovoltaic panel facing the light, a chamber filled with fluid is defined, with a heat exchange function for collecting the heat of the solar energy and/or the heat produced by the photovoltaic panel. The solar manifold assembly includes a second chamber also filled with fluid, located on a second side of the photovoltaic panel. The second chamber is partially defined by a part of the frame and a part of the second side of the photovoltaic panel. It is possible to arrange an array of hybrid photovoltaic panels side-by-side on an inclined roof. The panels may be interconnected to each other and to an AC/DC converter electrically coupled to the interconnected panel assemblies and configured to receive electrical energy therefrom.

DE 2020 19104195 U1 discloses a covering element for the construction of roofs, comprising chambers placed side-by-side on an inclined roof. Each chamber is located under an upper photovoltaic generator facing the sun. Longitudinal parallel heat exchange elements are mounted on the back of each generator.

WO 2020/161548 A2 discloses a column comprising a plurality of hybrid photovoltaic and thermal solar modules fluidically connected vertically with each other.

### Summary of the invention

It is an object of the present invention to increase, in a same building, the efficiency of the production of thermal energy from a solar thermal system and at the same time to increase the efficiency of the electricity production of a photovoltaic system.

These and other objects and advantages, which will be better clarified in the following, are achieved, according to the present invention, by a column comprising hybrid photovoltaic and thermal solar modules, having the features set forth in the accompanying claims. In summary, in a column of hybrid photovoltaic and thermal solar modules, each module comprises a supporting shell, which is advantageously monolithic, a front pane, which is at least partially transparent and which may optionally have elements for concentrating radiation, an internal photovoltaic generator, and a series of heat exchange elements on the rear surface of the photovoltaic generator. The shell forms a rear wall, and is closed at the front by the transparent pane. The photovoltaic generator divides the space between the at least partially transparent front pane and the rear wall of the shell into a front chamber and a rear chamber. The supporting shell is configured to allow fluid for the heat exchange to pass through the front chamber and the rear chamber.

According to one aspect, the present invention makes use of the vertical assembly of modules in order to enhance the upward effect of the flow of fluid moving in a front chamber (facing the sun) of a module of the column towards a corresponding and homologous front chamber of a module located immediately above the module considered. The front chambers of the modules of a column, fluidically connected to each other in such a way as to facilitate the passage of fluid, cooperate functionally in generating an upward flow. The cooling of the photovoltaic generators increases their production capacity, while the fluid is heated by collecting both the heat of the solar energy and that produced by the generators: the heated fluid is passed from one module to the other, through special communication orifices and sent to a special heat exchanger.

### Brief description of the drawings

The features and advantages of the present invention will be evident from the following description, given by way of non-limiting example. In the accompanying drawings:
FIG. 1 is an exploded perspective view of an individual hybrid solar module of the present invention;
FIG. 2B is a side sectional view that shows two joined hybrid solar modules;

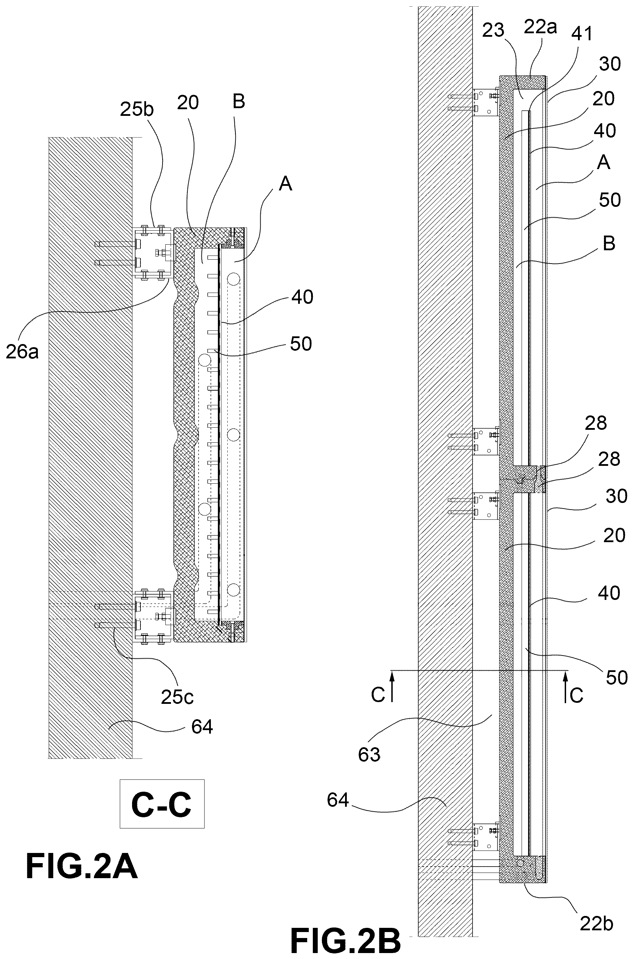

FIG. 2A is a view of a hybrid solar module in cross section along the plane C-C shown in side sectional view;

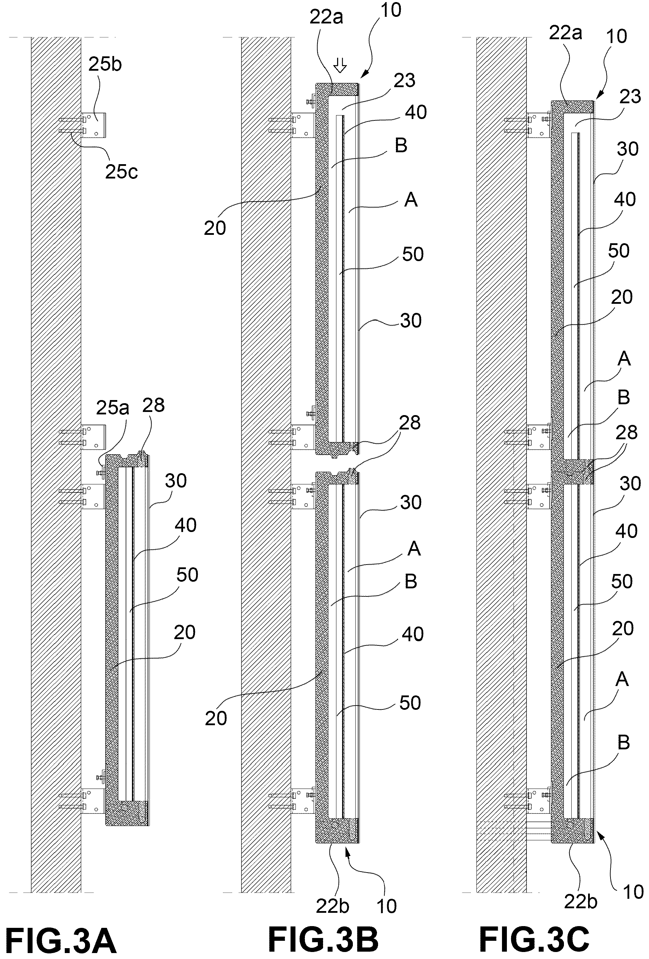

FIGs. 3A, 3B, and 3C are side sectional views that show the junction of an upper and a lower hybrid solar module, maintaining fluid continuity in the front and rear chambers of both the upper and lower module;

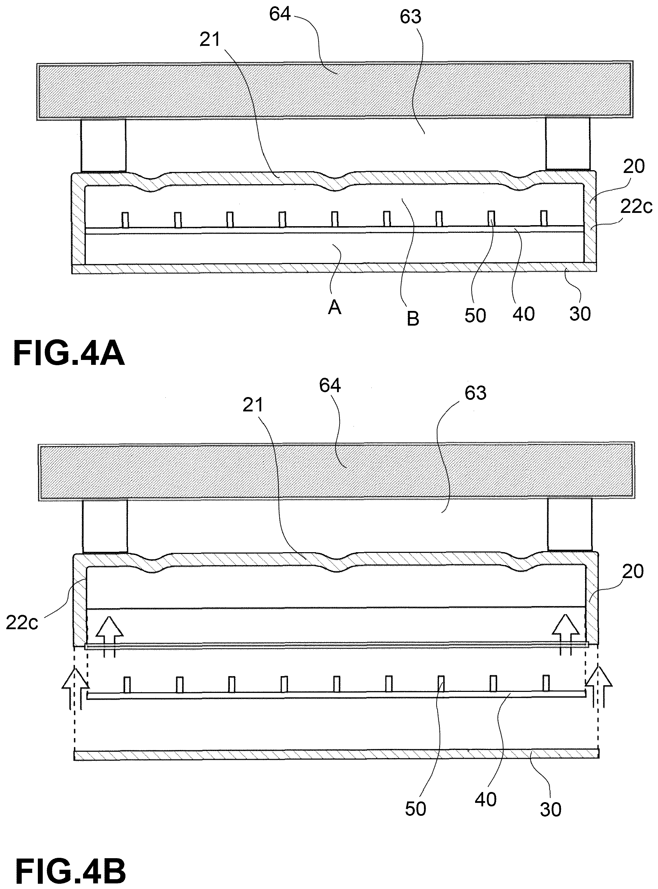

FIGs. 4A and 4B are cross-sectional views of a hybrid solar module with heat exchange elements fastened on a rear wall of a photovoltaic generator;

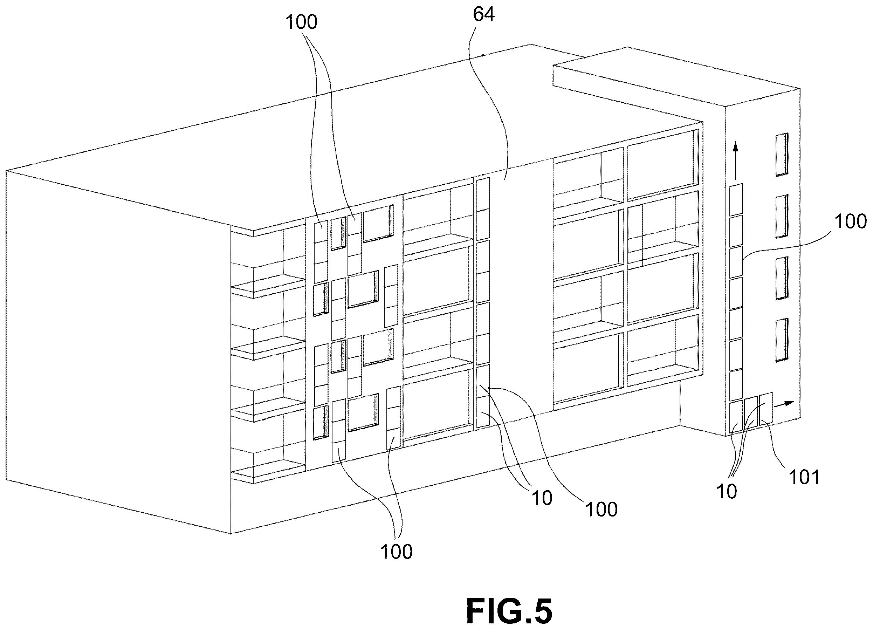

FIG. 5 is the perspective view of a building wherein there are a plurality of columns of hybrid solar modules;

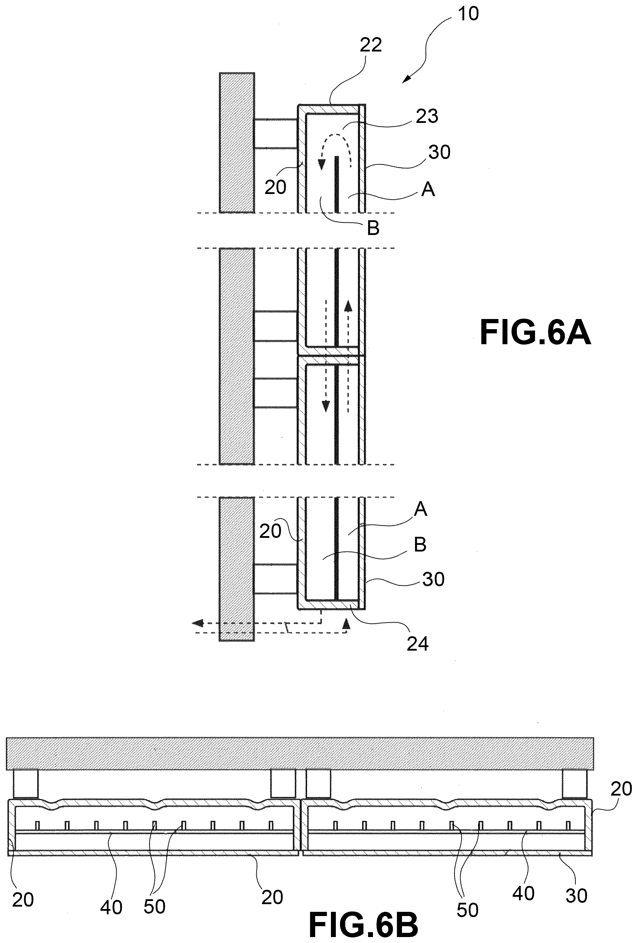

FIGs. 6A-B, 7A-C and 8A-C illustrate different architectural solutions with hybrid solar modules in different positions;

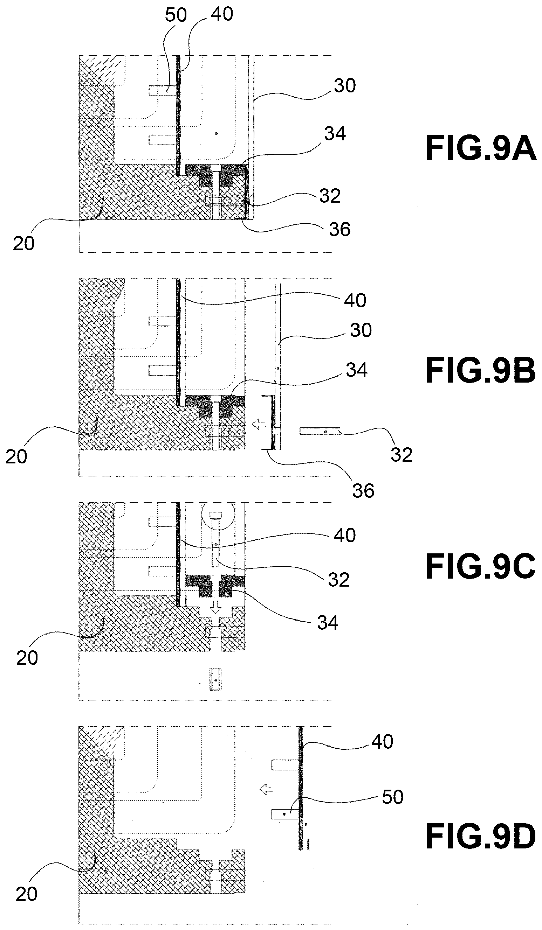

FIGs. 9A-D are partial and cross-sectional views showing the steps of assembly/disassembly of a photovoltaic generator and the front pane on a supporting shell by means of removable mechanical coupling elements;

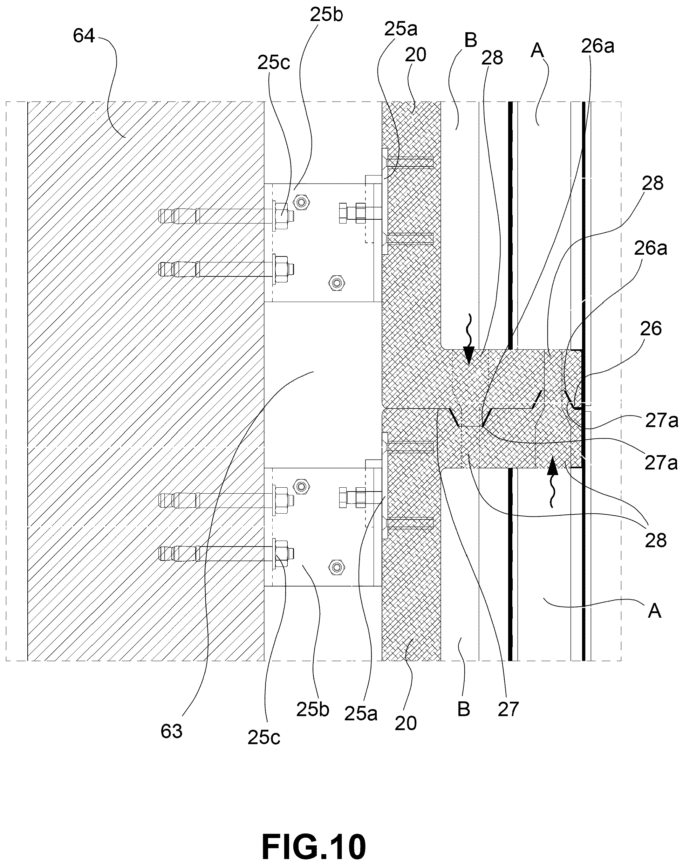

FIG. 10 is a partial side sectional view that shows upper and lower openings in the supporting shells of the lower and upper hybrid solar modules; and

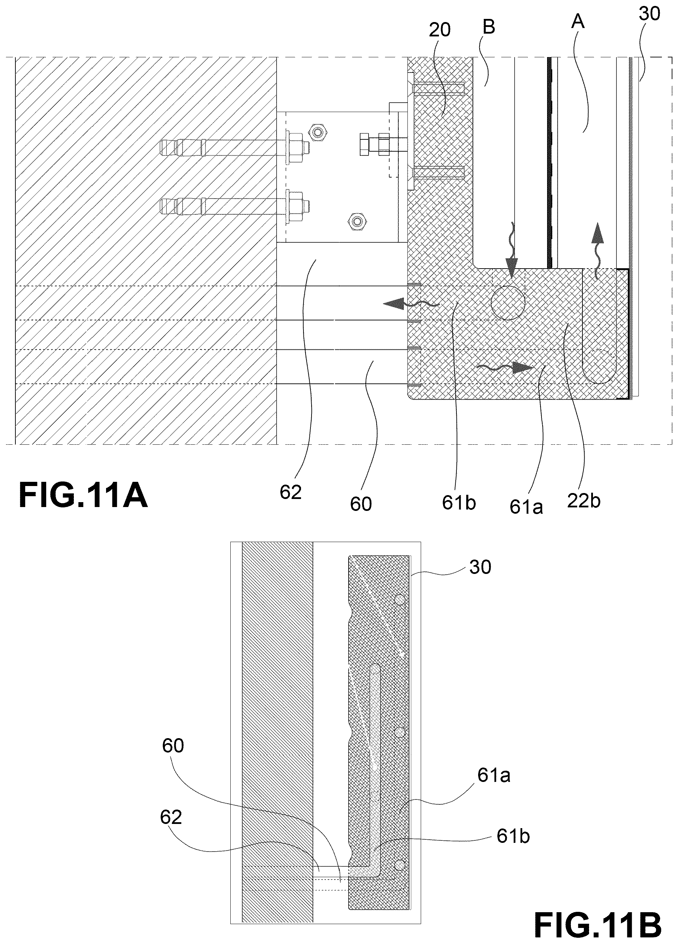

FIGs. 11A and 11B show a hybrid solar module having an inlet/delivery duct for the introduction of heat exchange fluid and an outlet/extraction duct for the fluid.

### Detailed description

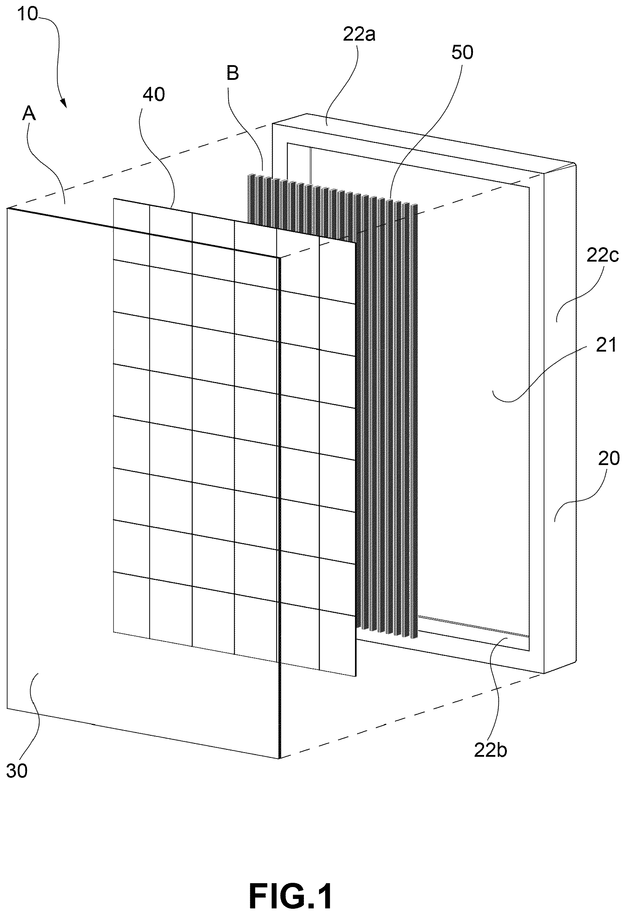

With reference to the drawings, according to a preferential embodiment, a hybrid photovoltaic and thermal solar module (or "PVT module") is indicated as a whole by reference number 10. The module 10 comprises a supporting shell 20 which has a rear wall 21, vertical in use, a front pane 30, at least partially transparent and vertical in use, which closes the shell 20 externally and anteriorly, and an internal photovoltaic generator 40 (FIG. 1).

The supporting shell 20 has an upper horizontal edge 22a and a lower horizontal edge 22b, and two vertical and parallel lateral edges 22c, which together with the vertical wall 21 make up the supporting shell 20.

The photovoltaic generator (or panel) 40 is arranged parallel to both the front pane 30 and the rear wall 21 and divides the space between the front pane 30 and the rear wall 21 into two chambers, namely a front chamber A and a rear chamber B (FIGs. 2A-B and 3A-C), which form two channels for fluid (which may be a gaseous flow, for example air), according to a modular configuration in which the module 10 is arranged side-by-side and communicating vertically and/or horizontally with other similar modules.

According to an embodiment, the front chamber A is used to form, together with other modules, a segment of a front channel for the upward flow of the fluid, while the rear chamber B is used to form, together with other modules, a rear channel for a downward flow of the fluid, preferably gaseous. The choice of the type of gaseous fluid is not to be considered as limiting.

According to an embodiment, the photovoltaic generator 40 may extend for the entire height and width of the supporting shell 20 so as to isolate the front chamber A from the rear chamber B.

According to an alternative embodiment, the photovoltaic generator 40 may only partially extend into the supporting shell 20 so as to identify with its upper horizontal edge 41 a top passage 23 (FIG. 2B) between the front chamber A and the rear chamber B of the hybrid solar module in order to allow the passage and reversal of the flow that rises from the front chamber A and descends into the rear chamber B.

According to an alternative embodiment, the front chamber A may be used to form, together with other modules, a segment of a channel for the downward flow of the fluid, while the opposite rear chamber B is used to form, together with other modules, a rear channel for the upward flow.

The photovoltaic generator 40 may be located equidistant between the front pane 30 and the rear wall 21, in order to make the volumes of the two front chambers A and rear chambers B substantially equivalent (FIG. 2A).

Alternatively, embodiment types not shown in the figures may mean that in some modules 10 the photovoltaic generator 40 is located closer to the front pane 30, in order to promote and accelerate the upward motion of the fluid present in the front chamber A.

In the preferred embodiment, the photovoltaic generator 40 may comprise a pane of tempered glass with a polymer film and photovoltaic cells, for example high-efficiency single-crystalline silicon cells. Alternatively, other types of generator may be used. The type of photovoltaic cells and the supporting pane, which form part of the photovoltaic generator 40, is not to be considered as limiting.

The glass pane of the photovoltaic generator has a rear surface to which an array of heat exchange elements 50 is fastened, configured for the gaseous flow in the rear chamber B to flow over them.

Preferably, the heat exchange elements 50 comprise straight elements which have a predetermined vertical orientation in use and are horizontally spaced apart from each other (FIGs. 4A-B).

According to a preferential embodiment, the heat exchange elements 50 are made of a metallic material and comprise fins made of aluminum and/or alloys thereof. The heat exchange elements 50, configured to be cooled by means of the flow of gaseous fluid moving within the rear chamber B, are arranged to absorb by conduction the heat generated by the photovoltaic cells.

The configuration (section, geometry, quantity, arrangement, etc.) and the material of the heat exchange elements 50 are chosen to offer a high exchange surface between the elements and the flow of fluid passing through the rear channel of the column.

In one embodiment, the photovoltaic generator 40 has a rear-facing surface to which an adherent metal foil, not shown in the drawings, preferably an aluminum foil, may be applied, on the back of which the heat exchange elements 50 are applied.

According to a typical configuration, two or more modules 10, continuously superimposed and vertically aligned with the respective front chambers A and rear chambers B in respective fluid communication, form a hybrid photovoltaic and thermal solar column 100 (FIG. 5). Alternatively or in combination with a vertical column 100, two or more modules 10 may be continuously aligned horizontally, connecting their respective front chambers A and rear chambers B, thus creating a series or "column" that extends horizontally 101 (FIG. 5).

As shown in FIGs. 6A, 6B, 7A, 7B, 7C, 8A, 8B, and 8C, various architectural solutions are possible with the use of the hybrid solar modules 10. According to one embodiment, two, three or more modules may be coupled together vertically in a "low module + high module" configuration and/or horizontally, according to a right module and left module lateral configuration.

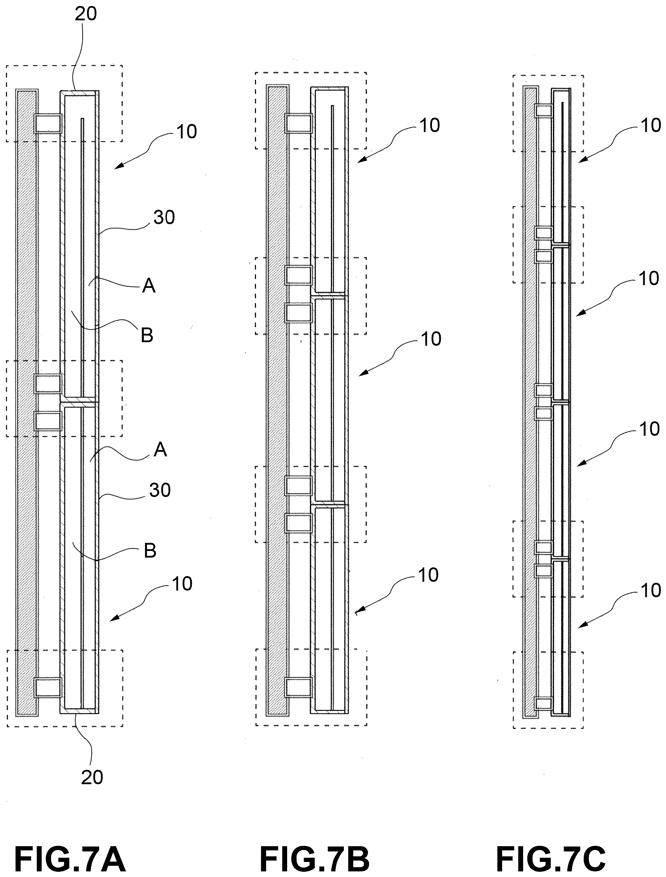

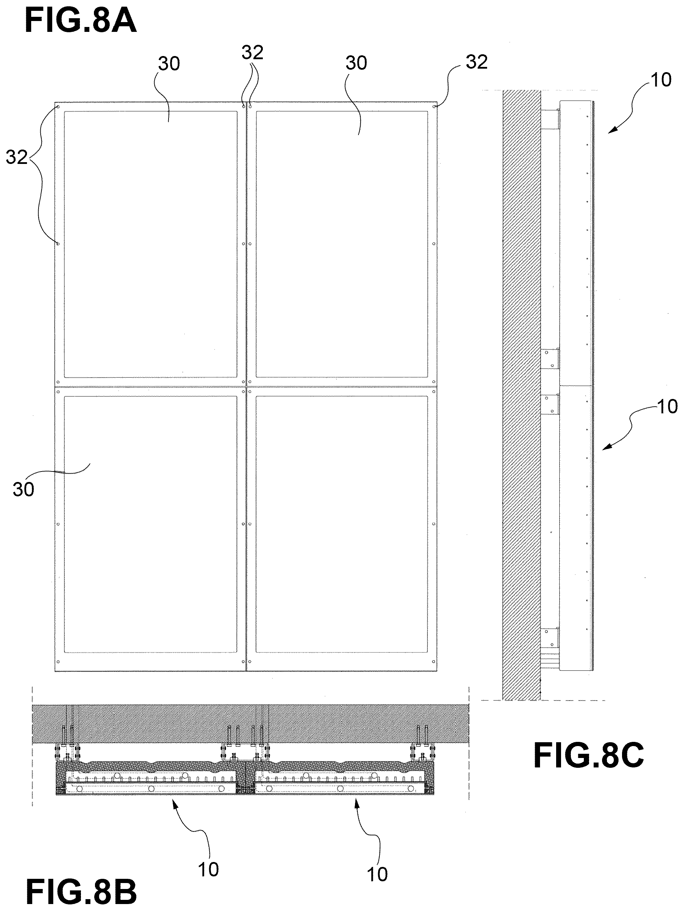

Optionally, the columns 100 of vertically combined modules may extend on the facade for the height of a floor of a conventional building (about 3 meters), as shown in FIG. 5. The system with two, three or more modules coupled in height/side, shown in the FIG. 6A-B and 7A-C, is compatible with a further aggregation development between modules to obtain a larger facade surface, shown in FIG. 8A-C, therefore, not only with respect to the vertical development but also the horizontal development. The connection between the modules may be either vertical - one above/below the other - or also horizontal - side-by-side - or both solutions simultaneously.

The hybrid solar modules may be configured to allow a combination of multiple pairs of modules according to a flexible layout capable of satisfying the most common cases of application on a facade of existing or new residential buildings. This also applies, with appropriate modifications, in the case of horizontal connection of the modules.

In order to allow the fluid communication between two or more hybrid solar modules, the module 10 has upper and/or lower and/or lateral openings 28 so as to be open at the top and/or at the bottom (FIGs. 2A-B and 3A-C) and/or laterally and may be coupled in a modular manner to at least one other adjacent module, vertically aligned above or below the module considered, or horizontally alongside it, and having similar and homologous chambers A and B which, placed in fluid communication with the homologous chambers of another underlying or overlying or laterally adjacent module 10, form together therewith two front and rear channels, respectively intended to allow the movement of the fluid, heated by solar radiation and by the heat developed by the photovoltaic cells, in a (typically upward) direction through the front chambers A, and the movement in the opposite direction (typically downward) in the return of the fluid through the rear chambers B.

In a preferred embodiment, the openings 28 are tapered or funnel-shaped in the direction of the flow (FIG. 2A-B and 3A-C). In other words, in two superimposed modules, the openings 28 in the front chamber A have a larger cross section in the lower hybrid solar module and a smaller cross section in the upper hybrid solar module so as to convey the rising fluid. Conversely, the openings in the rear chamber B are such as to convey the descending fluid.

In each column, the lower-lying hybrid solar module delimits the front chamber A and the rear chamber B at the bottom by means of the lower horizontal edge 22b.

The lower part of the shell 20, preferably the lower horizontal edge 22b, may have two or more through openings (FIG. 11), at least one inlet 61a and at least one outlet 61b of the fluid into/from the respective gaps of the front and rear chambers arranged for the inlet of fluid into the front chamber A and the outlet of fluid from the rear chamber B.

The front pane 30 of the hybrid solar module is at least partially transparent or reflective internally, i.e., it may be entirely transparent or even colored for aesthetic reasons.

According to an embodiment, the front pane 30 is made of glass, optionally colored, anti-reflective, tempered glass, preferably with high transmittance and low degree of absorption with respect to solar radiation, which allows the solar radiation to pass through without reflecting or absorbing it, or better yet, reflecting it inside, possibly at concentration. The choice of material constituting the front pane 30 is not to be considered as limiting.

The front chamber A is directly exposed to solar radiation and creates the conditions for heating the air present in the front chamber A between the front pane 30 and the photovoltaic generator 40. At the same time, the cold air introduced into the front chamber A helps to keep the temperature of the photovoltaic cells low.

The supporting shell 20 is preferably made of a rigid and lightweight material of various types; more preferably, the supporting shell 20 may be formed as a single monobloc element, as shown in FIG. 1.

Advantageously, the supporting shell 20 may be produced by digital manufacturing/additive manufacturing processes with large-format 3D printing. For example, Fused Deposition Modeling FDM may be exploited, using PLA (polylactic acid)-type thermoplastic filament materials with high mechanical strength and U.V. stability, high values of environmental sustainability and eco-compatibility. Alternatively, the supporting shell 20 may be made of other rigid materials, such as cement or plastics materials.

It is preferable that the technology and materials chosen to make the supporting shell 20 ensure the creation of through holes, cavities, pockets and seats for the integration of mechanical fastening systems (screws, bushings, nuts, bolts, plates, brackets, etc.) into the shell and the housing of elements to firmly anchor the supporting shell 20 to a wall of the building in the event of an energy upgrade of the building envelope. In the case of new construction, the supporting shell 20 may be integrated with the outer building envelope.

The front pane 30 may be sealingly coupled to the supporting shell 20, for example by means of a transparent structural adhesive with high mechanical strength, U.V. stability, and fluid tightness. Preferably, the front pane 30 is coupled to the supporting shell 20 by means of removable mechanical coupling elements 32, as shown in FIG. 8A-C and 9A-D, to allow assembly and disassembly and to allow installation, maintenance, and replacement of both internal and external components, as well as to ensure the dry assembly process of the transparent pane 30 to the supporting shell 20. For example, the removable mechanical coupling elements 32 may comprise threaded elements and/or sealing gaskets.

In particular, FIGs. 9A-D show assembly/disassembly steps of the photovoltaic generator 40 and of the front pane 30 to the supporting shell 20. The photovoltaic generator 40 is positioned within the supporting shell 20 facing the heat exchange elements 50 toward the rear wall 21.

In order to hermetically constrain the photovoltaic generator 40 to the supporting shell 20, as in the examples illustrated herein, a gasket 34 and/or removable mechanical coupling elements 32 may be used; alternatively, mechanical constraint means and hermetic fluid-tight sealing means alternative to those shown herein may also be provided.

The front pane 30 may provide for an engagement element 36, preferably with a C-shaped section, for engagement with the supporting shell 20. Furthermore, removable mechanical coupling elements 32 may be used to fasten the front pane 30 to the supporting shell 20, as shown in the example in FIG. 5. The same steps in reverse order may be performed to remove the front pane 30 from the supporting shell.

The supporting shells 20 may be fastened to the wall of the building by means of a mechanical anchoring system (FIG. 10), which may advantageously keep the modules horizontally spaced apart from the building, leaving a gap 63 between the building and the supporting shells 20. The mechanical anchoring system may comprise anchoring elements 25a for example, plate/angular elements of aluminum, directly embedded and mechanically integrated in housings formed in the supporting shell 20 (FIG. 10). Bracket spacer elements 25b may be arranged protruding from the wall 64 of the building, for example fastened by means of bolts 25c with a safety lock. The mechanical fastening system between the supporting shell and the peripheral load-bearing wall of the building is designed to ensure the reversibility of the hooking/unhooking steps for the set-up/maintenance/replacement operations of the hybrid PVT solar modules in the facade.

According to a preferred embodiment, the supporting shells are shaped so as to obtain a mutual shape coupling with vertically and/or horizontally contiguous modules.

Preferably (FIG. 10), the upper edges 22a and lower edges 22b of the supporting shells 20 form respective lower 26 and upper faces 27, each having formations 26a, 27a configured to couple with a corresponding conjugate formation 26a, 27a presented by an underlying or overlying or lateral module, to vertically/horizontally align and place the front chambers A and rear chambers B of the module considered and the underlying or overlying or lateral module in fluid communication.

In a preferred embodiment, peripheral portions of shells may have inclined V-shaped profiles to ensure a self-centering coupling between modules, as shown in FIG. 10, simultaneously providing the mechanical coupling and the continuity of the front and rear channels for the air flows to pass.

Through the edges 22a, 22b and/or 22c, special passages (not shown) are preferably formed for electrical cables for connecting to the photovoltaic generators 40 and for transferring the electrical energy generated in each hybrid module to the outside. Alternatively, the electrical cables may be passed through the through openings 28 in the edges 22a, 22b and/or 22c.

Interface gaskets between two consecutive shells may be preinstalled to ensure the hermetic sealing of the channels at the joints between two consecutive modules.

The aggregation and interlocking system between pairs of modules advantageously makes it possible to form vertical bands with interfloor height and more: it also allows for both vertically and horizontally continuous facades and allows a facade configuration with "continuous belt" horizontal development of hybrid PVT solar modules.

The operating diagram of the hybrid solar PVT module is as follows: the sun rays pass through the front pane 30, which is at least partially transparent, and hit the photovoltaic generator 40, which is positioned parallel or slightly inclined with respect to the front pane 30. In the front chamber A of a module located at the base of the column, between the front pane 30 and the photovoltaic generator 40, a fluid, for example air, may be introduced from below through the inlet opening 61a made in the lower horizontal edge 22b (FIG. 11A-11B).

Optionally, the fluid may be sent into the inlet/delivery duct 60 from a special centralized system (not shown). For this purpose, mechanical ventilation controlled by a ventilation system may be provided, which conveys the fluid by introducing it at the base of the front channel A. The fluid in the front chambers A of the front channel heats up due to solar radiation and contact with the photovoltaic generator 40.

Alternatively, and as required, the fluid may be introduced into the front chamber or channel A from above in a forced manner to produce a descending motion in the front chamber or channel A and rising motion in the rear chamber or channel B.

The fluid in the front chambers A of the column of modules rises (FIG. 10), due to convective motion and, optionally assisted by the action of forced ventilation from the base of the front channel, rises upwards within the front chamber A and hits the openings 28 passing through the front chambers A and/or the rear chambers B, in particular in the top module of each column. The heated fluid rises to the upper end of the front channel in the top module, passes through the top transverse passage 23 into the rear channel B and descends along it, between the rear walls 21 of the supporting shells 20 and the rear surfaces of the photovoltaic generators 40 (FIG. 10). The descending/rising fluid flows over the heat exchange elements 50, and heat is transferred to said fluid by convection, preventing overheating of the photovoltaic generators.

The choice of using the front rather than the rear chamber as the rising/descending chamber, raising/lowering the fluid for several modules or introducing cool fluid to each module by extracting the heated fluid module-by-module as an alternative to circulation on the three interfloor modules depends on the sun exposure of the building and the latitude thereof.

According to the temperature and application requirements, the descending flow in the rear chamber may be extracted from one or more of the modules, for example from the lower part of the module located lower in a column, for example through an outlet/extraction duct 62 emerging through the outlet opening 61b in the lower horizontal edge 22b (FIG. 11). The extracted hot fluid may optionally be recirculated and used to heat rooms, or conveyed to heat exchangers to preheat water ducts of thermal-sanitary systems, or to heat pumps for heating, and in summer, for large buildings, to electric thermal generators.

In one embodiment, the lower part/rear side of the shell of the lower module may accommodate plug-in plant-engineering connections of the fluid system to/from the central system, sealed and without dispersion.

For real-time management, monitoring, maintenance, and optimization of a building with photovoltaic and thermal generators, IoT and artificial intelligence may be used. These control energy production, improve the efficiency of photovoltaic generators, manage fluid flows and temperatures, and may create customized programs based on specific features of the building and/or individual homes.

The shells 20 may furthermore have edges with through openings (not shown in the figures) adapted to also allow the passage of electrical connections for the electrical energy produced by the photovoltaic generator 40.

Subject to the principle underlying the invention, the details of implementation and embodiments may vary widely from that which is described and illustrated, without departing from the scope of the present invention as identified by the claims that follow.

## Claims

1. Column comprising a plurality of hybrid photovoltaic and thermal solar modules fluidically connected vertically with each other, where each hybrid solar module (10) comprises:
- a supporting shell (20) forming a rear wall (21), vertical in use;
- a front pane (30), at least partially transparent, which closes the supporting shell (20) anteriorly and is opposite and parallel to the rear wall (21);
- an internal photovoltaic generator (40), which is arranged parallel to the front pane (30) and divides a space between the front pane and the rear wall (21) into a front chamber (A) and a rear chamber (B);
- a plurality of heat exchange elements (50) integral with a rear surface of the photovoltaic generator (40) facing the rear wall (21) of the supporting shell (20) and configured for a gaseous flow passing through the rear chamber (B) to flow over them;
wherein upper and/or lower openings (28) are formed in the supporting shell (20) to connect the front chamber (A) and the rear chamber (B) in fluid communication with, respectively, a front chamber and a rear chamber of another adjacent hybrid solar module (10) immediately overlying or underlying.

2. Column of hybrid solar modules according to claim 1, wherein the top module (10) comprises :
an upper horizontal edge (22a) which is formed by the supporting shell (20) and closes the front chamber (A) and the rear chamber (B) from above, and
a transverse passage (23), formed in a high part inside the module (10), which puts the front chamber (A) in fluid communication with the rear chamber (B).

3. Column of hybrid solar modules according to claim 1 or 2, wherein the supporting shell (20) of the bottom module (10) forms a lower horizontal edge (22b) delimiting the front chamber (A) and the rear chamber (B) at the bottom.

4. Column of hybrid solar modules according to any one of the preceding claims, wherein the heat exchange elements (50) comprise an array of rectilinear elements having a predetermined orientation and being spaced apart.

5. Column of hybrid solar modules according to claim 1 or 4, wherein the heat exchange elements (50) are arranged on a metal foil applied to a surface of the photovoltaic generator (40) facing the rear wall (21) of the supporting shell (20).

6. Column of hybrid solar modules according to any of the preceding claims, wherein the supporting shell (20) is a monolithic body.

7. Column of hybrid solar modules according to claim 6, wherein the supporting shell (20) is manufactured through digital manufacturing/additive manufacturing processes, and/or various types of concrete or demolition waste materials.

8. Column of hybrid solar modules according to any one of the preceding claims, wherein the supporting shell (20) is configured for receiving mechanical fastening means (25) to constrain the module to an external wall (64) of a building, or to construct curtain walls in buildings.

9. Column of hybrid solar modules according to claims 2 and 3, wherein the lower horizontal edge (22b) and the upper horizontal edge (22a) of the supporting shell (20) form a lower face (26) and an upper face (27) respectively, each having formations (26a, 27a) configured to couple with a corresponding mating formation (26a, 27a) presented by an underlying or overlying module, in order to vertically align and establish fluid communication between the front (A) and rear (B) chambers of the considered module and the underlying or overlying module.

10. Column of hybrid solar modules according to claims 2 and 3, wherein through said edges (22a, 22b, 22c) of the supporting shell (20) there are formed passages for electric cables connecting to the photovoltaic generators (40).

11. Column of hybrid solar modules according to claim 1, comprising at least one top module according to claim 2, and at least one bottom module according to claim 3, wherein the front chambers (A) and the rear chambers (B) of the modules are respectively connected in fluid communication so as to allow an upward fluid flow rising through a front channel formed by the union of the front chambers (A) flowing over the front surfaces of the photovoltaic generators (40), to pass through the transverse passage (23) formed in the top module, and to descend through a rear channel formed by the union of the rear chambers (B) of the modules, flowing over the heat exchange elements (50).

## Patentansprüche

1. Kolonne, umfassend eine Vielzahl von hybriden photovoltaischen und thermischen Solarmodulen, die fluidisch vertikal miteinander verbunden sind, wobei jedes hybride Solarmodul (10) umfasst:
eine Stützhülle (20), die eine Rückwand (21) bildet, die im Gebrauch vertikal ist;
eine Frontplatte (30), die mindestens teilweise transparent ist, die die Stützhülle (20) vorne verschließt und der Rückwand (21) gegenüberliegt und parallel ist;
einen inneren photovoltaischen Generator (40), der parallel zu der Frontplatte (30) angeordnet ist und einen Raum zwischen der Frontplatte und der Rückwand (21) in eine vordere Kammer (A) und eine hintere Kammer (B) unterteilt;
eine Vielzahl von Wärmeaustauschelementen (50), die mit einer Rückfläche des photovoltaischen Generators (40), die der Rückwand (21) der Stützhülle (20) zugewandt ist, einstückig ausgebildet sind und für einen gasförmigen Durchfluss konfiguriert sind, der durch die hintere Kammer (B) strömt, um über sie weg zu strömen;
wobei obere und/oder untere Öffnungen (28) in der Stützhülle (20) ausgebildet sind, um die vordere Kammer (A) und die hintere Kammer (B) in Fluidverbindung mit jeweils einer vorderen Kammer und einer hinteren Kammer eines anderen unmittelbar darüber liegenden oder darunter liegenden angrenzenden hybriden Solarmoduls (10) zu bringen.

2. Kolonne von hybriden Solarmodulen nach Anspruch 1, wobei das obere Modul (10) umfasst:
ein oberer horizontaler Rand (22a), der von der Stützhülle (20) gebildet wird und die vordere Kammer (A) und die hintere Kammer (B) von oben verschließt, und
eine Querpassage (23), die in dem oberen Bereich innerhalb des Moduls (10) ausgebildet ist und die vordere Kammer (A) in Fluidverbindung mit der hinteren Kammer (B) bringt.

3. Kolonne von hybriden Solarmodulen nach Anspruch 1 oder 2, wobei die Stützhülle (20) des unteren Moduls (10)
ein unterer horizontaler Rand (22b) bildet, der die vordere Kammer (A) und die hintere Kammer (B) an dem Boden begrenzt.

4. Kolonne von hybriden Solarmodulen nach einem der vorhergehenden Ansprüche, wobei die Wärmeaustauschelemente (50) eine Anordnung von geradlinigen Elementen aufweisend eine vorgegebene Ausrichtung und die zueinander beabstandet sind, umfassen.

5. Kolonne von hybriden Solarmodulen nach Anspruch 1 oder 4, wobei die Wärmeaustauschelemente (50) auf einer Metallfolie angeordnet sind, die auf einer Oberfläche des photovoltaischen Generators (40), die dem Rückwand (21) der Stützhülle (20) zugewandt ist, angebracht wird.

6. Kolonne von hybriden Solarmodulen nach einem der vorhergehenden Ansprüche, wobei die Stützhülle (20) ein monolithischer Körper ist.

7. Kolonne von hybriden Solarmodulen nach Anspruch 6, wobei die Stützhülle (20) durch digitale Fertigung/Additive-Fertigungsverfahren und/oder verschiedene Arten von Beton oder Abbruchmaterialien hergestellt wird.

8. Kolonne von hybriden Solarmodulen nach einem der vorhergehenden Ansprüche, wobei die Stützhülle (20) dazu konfiguriert ist, mechanische Befestigungsmittel (25) aufzunehmen, um das Modul an einer Außenwand (64) eines Gebäudes zu befestigen oder um Vorhangfassaden in Gebäuden zu errichten.

9. Kolonne von hybriden Solarmodulen nach den Ansprüchen 2 und 3, wobei der untere horizontale Rand (22b) und der obere horizontale Rand (22a) der Stützhülle (20) jeweils eine untere Fläche (26) und eine obere Fläche (27) bilden, die jeweils Strukturen (26a, 27a) aufweisen, die dazu konfiguriert sind, mit einer entsprechenden komplementären Struktur (26a, 27a) gekoppelt zu werden, die durch eines darunter- oder darüberliegenden Moduls bereitgestellt wird, um eine vertikale Ausrichtung herzustellen und eine Fluidverbindung zwischen den vorderen (A) und hinteren (B) Kammern des betreffenden Moduls und dem darunter- oder darüberliegenden Modul zu schaffen.

10. Kolonne von hybriden Solarmodulen nach den Ansprüchen 2 und 3, wobei Öffnungen durch die Ränder (22a, 22b, 22c) der Stützhülle für Elektrokabel gebildet sind, die mit den photovoltaischen Generatoren (40) verbunden sind.

11. Kolonne von hybriden Solarmodulen nach Anspruch 1, umfassend mindestens ein oberes Modul nach Anspruch 2 und mindestens ein unteres Modul nach Anspruch 3, wobei die vorderen Kammern (A) und die hinteren Kammern (B) der Module jeweils in Fluidverbindung verbunden sind, um eine ansteigende Flüssigkeitsströmung zu ermöglichen, die durch einen vorderen Kanal ansteigt, der durch die Verbindung der vorderen Kammer (A) gebildet wird, indem sie über die vorderen Oberflächen der photovoltaischen Generatoren (40) strömt, um durch die Querpassage (23) hindurch zu strömen, die in dem oberen Modul gebildet wird und durch einen hinteren Kanal abzusteigen, der durch die Verbindung der hinteren Kammern (B) der Module gebildet wird, indem sie über die Wärmeaustauschelemente (50) strömt.

## Revendications

1. Colonne comprenant une pluralité de modules solaires hybrides photovoltaïques et thermiques connectés verticalement entre eux de manière fluidique, chaque module solaire hybride (10) comprenant :
une coque de support (20) formant une paroi arrière (21), verticale en usage ;
une vitre frontale (30), au moins partiellement transparente, qui ferme antérieurement la coque de support (20) et est opposée et parallèle à la paroi arrière (21) ;
un générateur photovoltaïque interne (40), qui est disposé parallèlement à la vitre frontale (30) et divise un espace entre la vitre frontale et la paroi arrière (21) en une chambre frontale (A) et une chambre arrière (B) ;
une pluralité d'éléments d'échange thermique (50) solidaires d'une surface arrière du générateur photovoltaïque (40) faisant face à la paroi arrière (21) de la coque de support (20) et configurés pour qu'un flux gazeux passant par la chambre arrière (B) s'écoule dessus ;
dans laquelle des ouvertures supérieures et/ou inférieures (28) sont formées dans la coque de support (20) pour mettre la chambre frontale (A) et la chambre arrière (B) en communication fluidique respectivement avec une chambre frontale et une chambre arrière d'un autre module solaire hybride (10) adjacent immédiatement sus-jacent ou sous-jacent.

2. Colonne de modules solaires hybrides selon la revendication 1, dans laquelle le module supérieur (10) comprend :
un bord horizontal supérieur (22a) qui est formé par la coque de support (20) et ferme la chambre frontale (A) et la chambre arrière (B) par le haut, et
un passage transversal (23), formé dans une partie haute à l'intérieur du module (10), qui met la chambre frontale (A) en communication fluidique avec la chambre arrière (B).

3. Colonne de modules solaires hybrides selon la revendication 1 ou 2, dans laquelle la coque de support (20) du module inférieur (10) forme un bord horizontal inférieur (22b) délimitant la chambre frontale (A) et la chambre arrière (B) à la base.

4. Colonne de modules solaires hybrides selon l'une quelconque des revendications précédentes, dans laquelle les éléments d'échange thermique (50) comprennent un réseau d'éléments rectilignes ayant une orientation prédéterminée et étant espacés entre eux.

5. Colonne de modules solaires hybrides selon la revendication 1 ou 4, dans laquelle les éléments d'échange thermique (50) sont disposés sur une feuille métallique appliquée sur une surface du générateur photovoltaïque (40) faisant face à la paroi arrière (21) de la coque de support (20).

6. Colonne de modules solaires hybrides selon l'une quelconque des revendications précédentes, dans laquelle la coque de support (20) est un corps monolithique.

7. Colonne de modules solaires hybrides selon la revendication 6, dans laquelle la coque de support (20) est réalisée par des procédés de fabrication numérique / fabrication additive, et/ou à partir de différents types de béton ou de matériaux provenant de démolitions.

8. Colonne de modules solaires hybrides selon l'une quelconque des revendications précédentes, dans laquelle la coque de support (20) est configurée pour recevoir des moyens de fixation mécanique (25) afin de fixer le module à une paroi externe (64) d'un bâtiment, ou pour construire des murs-rideaux dans les bâtiments.

9. Colonne de modules solaires hybrides selon les revendications 2 et 3, dans laquelle le bord horizontal inférieur (22b) et le bord horizontal supérieur (22a) de la coque de support (20) forment respectivement une face inférieure (26) et une face supérieure (27), chacune présentant des formations (26a, 27a) configurées pour s'accoupler à une formation correspondante complémentaire (26a, 27a) présentée par un module sous-jacent ou sus-jacent, afin d'aligner verticalement et d'établir une communication fluidique entre les chambres frontale (A) et arrière (B) du module considéré et le module sous-jacent ou sus-jacent.

10. Colonne de modules solaires hybrides selon les revendications 2 et 3, dans laquelle des passages pour câbles électriques reliant les générateurs photovoltaïques (40) sont formés à travers lesdits bords (22a, 22b, 22c) de la coque de support (20).

11. Colonne de modules solaires hybrides selon la revendication 1, comprenant au moins un module supérieur selon la revendication 2, et au moins un module inférieur selon la revendication 3, dans laquelle les chambres frontales (A) et les chambres arrière (B) des modules sont respectivement connectées en communication fluidique de manière à permettre un flux fluide ascendant montant à travers un canal frontal formé par l'union des chambres frontales (A), s'écoulant sur les surfaces frontales des générateurs photovoltaïques (40), pour passer à travers le passage transversal (23) formé dans le module supérieur, et descendre à travers un canal arrière formé par l'union des chambres arrière (B) des modules, s'écoulant sur les éléments d'échange thermique (50).
